# EUROPEAN PATENT APPLICATION

(11) **EP 4 773 140 A1**
(43) Date of publication of application: **08.07.2026**
(21) Application number: 25818123.9
(22) Date of filing: 27.05.2025
(51) Int. Cl.: G11C 11/4074, G11C 11/4076, H03L 7/081

(54) **CLOCK TRANSMISSION CIRCUIT, PHASE CALIBRATION METHOD, AND MEMORY**

(30) Priority: 29.08.2024 CN 202411206661
(71) Applicant: CXMT Corporation, Hefei, Anhui 230601 (CN)
(72) Inventor: LIN, Feng, Hefei, Anhui 230601 (CN); DING, Lei, Hefei, Anhui 230601 (CN); SHENG, Jiechao, Hefei, Anhui 230601 (CN)
(74) Representative: Gulde & Partner
(86) International application number: PCT/CN2025/097304
(87) International publication number: WO 2026/045424

(57) **Abstract**

The present disclosure provides a clock transmission circuit, a method for phase calibration, and a memory. The clock transmission circuit includes: a first clock distribution network, a second clock distribution network, and a phase calibration module. The first clock distribution network and the second clock distribution network respectively receive a first input clock signal and a second input clock signal, transmit the first input clock signal and the second input clock signal to an output port area, and output a first target clock signal and a second target clock signal. When in a normal operating mode, a phase difference between the second input clock signal and the first input clock signal is a preset value; when in a calibration mode, the second input clock signal is in phase with the first input clock signal. When in the calibration mode, the phase calibration module receives the first target clock signal and the second target clock signal and outputs, according to a phase difference between the first target clock signal and the second target clock signal, a first phase calibration code. The first phase calibration code is used to adjust a delay of the second clock distribution network; the phase difference between the first target clock signal and the second target clock signal is less than a preset threshold when calibration is completed. The present disclosure is at least beneficial for ameliorating phase differences between multi-phase clock signals and shortening the test time.

## Description

The present application claims priority to Chinese Patent Application No. 202411206661.X filed with China National Intellectual Property Administration on August 29, 2024, and entitled "CLOCK TRANSMISSION CIRCUIT, METHOD FOR PHASE CALIBRATION, AND MEMORY", the content of which is incorporated herein by reference in its entirety.

### TECHNICAL FIELD

Embodiments of the present disclosure relate to the technical field of semiconductors, and in particular, to a clock transmission circuit, a method for phase calibration, and a memory.

### BACKGROUND

In a memory system, data is usually transmitted according to a certain timing. The normal operation of a memory depends on the accurate timing of internal commands and clocks. In a dynamic random access memory (dynamic random access memory, DRAM), a delay locked loop needs to perform phase synchronization and locking on four-phase clock signals (i.e., four clock signals whose phases differ successively by 90 degrees), so as to subsequently generate a data strobe signal DQS. In addition, the data strobe signal DQS is used for the sampling processing of a data signal DQ. However, as the operating frequency of the memory increases, in the process of phase synchronization and locking, phase differences between the four-phase clock signals may exhibit significant skew relative to the target value.

### SUMMARY

Embodiments of the present disclosure provide a clock transmission circuit, a method for phase calibration, and a memory, which are at least beneficial for improving phase differences between multi-phase clock signals and shortening test time.

In a first aspect, the embodiments of the present disclosure provide a clock transmission circuit. The clock transmission circuit is applied to a memory and includes:
a first clock distribution network configured to receive a first input clock signal, transmit the first input clock signal to an output port area of the memory, and output a first target clock signal;
a second clock distribution network configured to receive a second input clock signal, transmit the second input clock signal to the output port area of the memory, and output a second target clock signal, where the phase difference between the second input clock signal and the first input clock signal is a preset value when the memory is in a normal operating mode, and the second input clock signal is in phase with the first input clock signal when the memory is in a calibration mode; and
a phase calibration module configured to receive the first target clock signal and the second target clock signal and output, according to the phase difference between the first target clock signal and the second target clock signal, a first phase calibration code when the memory is in the calibration mode, where the first phase calibration code is used to adjust the delay of the second clock distribution network, and the phase difference between the first target clock signal and the second target clock signal is less than a preset threshold when calibration is completed.

In some embodiments, the clock transmission circuit further includes:
a delay locked loop, where the delay locked loop at least includes a first adjustable delay line, where the first adjustable delay line receives a first clock signal and a control code, performs delay processing on the first clock signal based on the control code, and outputs a first delayed clock signal; and
a multi-phase clock generation circuit electrically connected to the first adjustable delay line and configured to: receive the first delayed clock signal and generate, based on the first delayed clock signal, at least a first phase clock signal and a second phase clock signal when the operating frequency of the memory is greater than or equal to a preset frequency, where the first phase clock signal is in phase with the first delayed clock signal, and the phase difference between the second phase clock signal and the first phase clock signal is the preset value; and be disabled when the operating frequency of the memory is less than the preset frequency.

In some embodiments, the clock transmission circuit further includes:
a first mode control circuit electrically connected to the multi-phase clock generation circuit, the first clock distribution network, and the second clock distribution network and configured to: receive the first phase clock signal and the second phase clock signal; transmit the first phase clock signal to the first clock distribution network as the first input clock signal and transmit the second phase clock signal to the second clock distribution network as the second input clock signal when the operating frequency of the memory is greater than or equal to the preset frequency and the memory is in the normal operating mode; and transmit the first phase clock signal to the first clock distribution network and the second clock distribution network as both the first input clock signal and the second input clock signal when the operating frequency of the memory is greater than or equal to the preset frequency and the memory is in the calibration mode.

In some embodiments, the delay locked loop further includes a second adjustable delay line, where the second adjustable delay line is configured to: receive a second clock signal when the operating frequency of the memory is less than the preset frequency and the memory is in the normal operating mode; receive the first clock signal when the operating frequency of the memory is less than the preset frequency and the memory is in the calibration mode; perform delay processing on the received signal based on the control code and output a second delayed clock signal; and be disabled when the operating frequency of the memory is greater than or equal to the preset frequency.

In some embodiments, the first mode control circuit is further electrically connected to the second adjustable delay line, receives the second delayed clock signal, and transmits the first delayed clock signal to the first clock distribution network as the first input clock signal and transmits the second delayed clock signal to the second clock distribution network as the second input clock signal when the operating frequency of the memory is less than the preset frequency.

In some embodiments, the clock transmission circuit further includes:
a second mode control circuit electrically connected to the first adjustable delay line and the second adjustable delay line and configured to: transmit the first clock signal to the first adjustable delay line and transmit the second clock signal to the second adjustable delay line when the operating frequency of the memory is less than the preset frequency and the memory is in the normal operating mode; transmit the first clock signal to both the first adjustable delay line and the second adjustable delay line when the operating frequency of the memory is less than the preset frequency and the memory is in the calibration mode; and transmit the first clock signal to the first adjustable delay line when the operating frequency of the memory is greater than or equal to the preset frequency.

In some embodiments, the first adjustable delay line and the second adjustable delay line share the same circuit structure.

In some embodiments, the clock transmission circuit further includes a clock distribution network replica receiving the first input clock signal, emulating the delay of the first clock distribution network, and outputting a target clock signal replica.

In some embodiments, the delay locked loop further includes:
a delay emulation circuit receiving the target clock signal replica and configured to emulate delays of a clock input path and a clock output path in the memory and output a feedback clock signal, where the clock input path includes a clock receiver and a frequency divider, and the clock output path includes an output driving circuit;
a first phase detector electrically connected to the delay emulation circuit and configured to receive the feedback clock signal and a reference clock signal and output, based on the phase sequence of the feedback clock signal and the reference clock signal, a first indication signal; and
a control code generation circuit electrically connected to the first phase detector and configured to adjust and output the control code based on the first indication signal.

In some embodiments, the delay locked loop has completed phase locking before the memory enters the calibration mode.

In some embodiments, the phase calibration module includes:
a second phase detector receiving the first target clock signal and the second target clock signal and outputting, based on the phase sequence of the first target clock signal and the second target clock signal, a second indication signal; and
a first calibration code generation circuit electrically connected to the second phase detector and configured to adjust and output the first phase calibration code based on the second indication signal.

In some embodiments, the second clock distribution network includes an adjustable delay module, where the adjustable delay module receives the first phase calibration code and adjusts its own delay in response to the first phase calibration code.

In some embodiments, the adjustable delay module includes a plurality of delay units, where each delay unit is enabled or disabled in response to one bit in the first phase calibration code.

In some embodiments, the first calibration code generation circuit includes:
a shift register configured to receive the second indication signal, perform a left shift or a right shift according to the second indication signal, and output the first phase calibration code.

In some embodiments, the clock transmission circuit further includes:
a register configured to store the first phase calibration code after the calibration mode is completed and transmit the first phase calibration code to the second clock distribution network when the memory is in the normal operating mode.

In some embodiments, the phase calibration module stops operating after the calibration mode is completed.

In some embodiments, the clock transmission circuit further includes:
a third clock distribution network configured to receive a third input clock signal, transmit the third input clock signal to the output port area of the memory, and output a third target clock signal, where the phase difference between the third input clock signal and the second input clock signal is 90 degrees when the memory is in the normal operating mode, and the third input clock signal is in phase with the first input clock signal when the memory is in the calibration mode; and
a fourth clock distribution network configured to receive a fourth input clock signal, transmit the fourth input clock signal to the output port area of the memory, and output a fourth target clock signal, where the phase difference between the fourth input clock signal and the third input clock signal is 90 degrees when the memory is in the normal operating mode, and the fourth input clock signal is in phase with the first input clock signal when the memory is in the calibration mode;
the phase calibration module is further configured to: receive the third target clock signal and the fourth target clock signal and output, according to the phase difference between the third target clock signal and the first target clock signal, a second phase calibration code when the memory is in the calibration mode, where the second phase calibration code is used to adjust the delay of the third clock distribution network; and output, according to the phase difference between the fourth target clock signal and the first target clock signal, a third phase calibration code, where the third phase calibration code is used to adjust the delay of the fourth clock distribution network; when the calibration is completed, the phase difference between the first target clock signal and the third target clock signal is less than the preset threshold, and the phase difference between the first target clock signal and the fourth target clock signal is less than the preset threshold.

In some embodiments, the delay locked loop further includes:
a third adjustable delay line configured to: receive a third clock signal when the operating frequency of the memory is less than the preset frequency and the memory is in the normal operating mode; receive the first clock signal when the operating frequency of the memory is less than the preset frequency and the memory is in the calibration mode; perform delay processing on the received signal based on the control code and output a third delayed clock signal; and be disabled when the operating frequency of the memory is greater than or equal to the preset frequency; and
a fourth adjustable delay line configured to receive a fourth clock signal when the operating frequency of the memory is less than the preset frequency and the memory is in the normal operating mode; receive the first clock signal when the operating frequency of the memory is less than the preset frequency and the memory is in the calibration mode; perform delay processing on the received signal based on the control code and output a fourth delayed clock signal; and be disabled when the operating frequency of the memory is greater than or equal to the preset frequency;
the phases of the first clock signal, the second clock signal, the third clock signal, and the fourth clock signal differ successively by 90 degrees.

In some embodiments, the multi-phase clock generation circuit is further configured to generate a third phase clock signal and a fourth phase clock signal based on the first delayed clock signal, where the phases of the first phase clock signal, the second phase clock signal, the third phase clock signal, and the fourth phase clock signal differ successively by 90 degrees;
the first mode control circuit is further electrically connected to the third adjustable delay line and the fourth adjustable delay line and configured to: receive the third phase clock signal, the fourth phase clock signal, the third delayed clock signal, and the fourth delayed clock signal; transmit the third phase clock signal to the third clock distribution network as the third input clock signal and transmit the fourth phase clock signal to the fourth clock distribution network as the fourth input clock signal when the operating frequency of the memory is greater than or equal to the preset frequency and the memory is in the normal operating mode; transmit the first phase clock signal to the third clock distribution network and the fourth clock distribution network as both the third input clock signal and the fourth input clock signal when the operating frequency of the memory is greater than or equal to the preset frequency and the memory is in the calibration mode; and transmit the third delayed clock signal to the third clock distribution network as the third input clock signal and transmit the fourth delayed clock signal to the fourth clock distribution network as the fourth input clock signal when the operating frequency of the memory is less than the preset frequency; and
the second mode control circuit is further electrically connected to the third adjustable delay line and the fourth adjustable delay line and configured to: transmit the third clock signal to the third adjustable delay line and transmit the fourth clock signal to the fourth adjustable delay line when the operating frequency of the memory is less than the preset frequency and the memory is in the normal operating mode; and transmit the first clock signal to both the third adjustable delay line and the fourth adjustable delay line when the operating frequency of the memory is less than the preset frequency and the memory is in the calibration mode.

In some embodiments, the clock frequencies of the first clock signal, the second clock signal, the third clock signal, and the fourth clock signal are half of the clock frequency of an initial clock signal received by the memory, where the clock frequency of the initial clock signal is equal to the operating frequency of the memory.

In some embodiments, the phase calibration module includes:
a third phase detector receiving the first target clock signal and the third target clock signal and outputting, based on the phase sequence of the first target clock signal and the third target clock signal, a third indication signal;
a second calibration code generation circuit electrically connected to the third phase detector and configured to adjust and output the second phase calibration code based on the third indication signal;
a fourth phase detector receiving the first target clock signal and the fourth target clock signal and outputting, based on the phase sequence of the first target clock signal and the fourth target clock signal, a fourth indication signal; and
a third calibration code generation circuit electrically connected to the fourth phase detector and configured to adjust and output the third phase calibration code based on the fourth indication signal.

In a second aspect, the embodiments of the present disclosure provide a method for phase calibration. The method is applied to a memory and includes:
inputting a first input clock signal to a first clock distribution network, transmitting the first input clock signal to an output port area of the memory, and outputting a first target clock signal;
inputting a second input clock signal to a second clock distribution network, transmitting the second input clock signal to the output port area of the memory, and outputting a second target clock signal;
controlling the second input clock signal to be in phase with the first input clock signal when the memory is in a calibration mode;
receiving the first target clock signal and the second target clock signal, and outputting, according to the phase difference between the first target clock signal and the second target clock signal, a first phase calibration code; and
adjusting the delay of the second clock distribution network according to the first phase calibration code, where the phase difference between the first target clock signal and the second target clock signal is less than a preset threshold when calibration is completed.

In a third aspect, the embodiments of the present disclosure provide a memory. The memory at least includes the clock transmission circuit according to the first aspect.

The technical solutions provided according to the embodiments of the present disclosure at least have the following advantages:
When the memory is in the calibration mode, the first clock distribution network and the second clock distribution network transmit in-phase clock signals, and the delay of the second clock distribution network is adjusted according to the phase difference between the transmitted signals, thereby matching the delay of the first clock distribution network with the delay of the second clock distribution network. In this way, when the memory operates normally, the skew in the phase difference between the first target clock signal and the second target clock signal relative to the target value can be reduced, which is beneficial for data transmission. In addition, the setting of the calibration mode can also shorten the test time.

### BRIEF DESCRIPTION OF DRAWINGS

One or more embodiments are illustrated by figures in the corresponding drawings. These exemplary explanations do not constitute limitations on the embodiments, and elements with identical reference numerals in the drawings represent similar elements. Unless expressly stated otherwise, the figures in the drawings do not constitute a scale limitation. To more clearly illustrate the technical solutions in the embodiments of the present disclosure or the conventional technology, a brief introduction to the drawings required for the description of the embodiments is given hereinafter. It is evident that the drawings described hereinafter are merely some embodiments of the present disclosure. For those of ordinary skill in the art, other drawings may also be obtained according to these drawings without creative effort.
FIG. 1 is a schematic structural diagram of a clock transmission circuit;
FIG. 2 is a schematic structural diagram of a clock transmission circuit provided according to an embodiment of the present disclosure;
FIG. 3 is a schematic structural diagram of another clock transmission circuit provided according to an embodiment of the present disclosure;
FIG. 4 is a waveform diagram of a clock transmission circuit provided according to an embodiment of the present disclosure;
FIG. 5 is a schematic structural diagram of another clock transmission circuit provided according to an embodiment of the present disclosure;
FIG. 6 is a schematic flowchart of a method for phase calibration provided according to an embodiment of the present disclosure; and
FIG. 7 is a schematic structural diagram of a memory provided according to an embodiment of the present disclosure.

### DESCRIPTION OF EMBODIMENTS

The technical solutions in embodiments of the present disclosure will be clearly and completely described below with reference to the drawings in the embodiments of the present disclosure. It can be understood that the specific embodiments described herein are merely illustrative of a related application and are not intended to limit the application. In addition, it should be noted that for the convenience of description, only the portions relevant to the related application are shown in the drawings. Unless otherwise defined, all technical and scientific terms used herein have the same meaning as commonly understood by those skilled in the art to which the present disclosure belongs. The terms used herein are for the purpose of describing the embodiments of the present disclosure only and are not intended to limit the present disclosure. In the following description, reference is made to "some embodiments", which describe subsets of all possible embodiments, but it can be understood that "some embodiments" may be the same subset or different subsets of all possible embodiments, and may be combined with each other as long as there is no conflict. It should be noted that the terms "first/second/third" referred to in the embodiments of the present disclosure are merely used to distinguish similar objects and do not represent a specific ordering for the objects. It can be understood that "first/second/third" may be subjected to interchange of a specific order or sequence if permitted, such that the embodiments of the present disclosure described herein can be implemented in an order other than that shown or described herein.
Dynamic random access memory (dynamic random access memory, DRAM)
Synchronous dynamic random access memory (synchronous dynamic random access memory, SDRAM)
Double data rate SDRAM (double data rate SDRAM, DDR SDRAM)
Low power DDR (low power DDR, LPDDR)
DDRn specification (DDRn specification, DDRn), e.g., DDR3, DDR4, DDR5, or DDR6
LPDDRn specification (LPDDRn specification, LPDDRn), e.g., LPDDR3, LPDDR4, LPDDR5, or LPDDR6
Delay locked loop (delay locked loop, DLL)

A clock is a very important component of a digital circuit and provides a stable time reference such that various parts of the digital circuit can operate based on a predetermined timing. In a memory, the clock also plays a very important role. Data in the memory is usually transmitted according to a certain timing. A clock signal is capable of controlling the input and output of data, ensuring that data is read or written at the correct point in time. Through the synchronous action of the clock, the memory can coordinate with other digital circuit components, ensuring accuracy and reliability of data transmission.

As the operating frequency of the memory continues to increase, the frequency of the received initial clock signal becomes increasingly high, and therefore, the frequency division needs to be performed inside the memory to generate internal multi-phase clock signals for data processing. The phase difference between the multi-phase clock signals is related to the quality of the final output data of the memory. Taking DDR5 DRAM as an example, in order to achieve high-frequency operation of a memory, four-phase clock signals are generated inside the memory based on an initial clock signal for data processing. Ideally, the four-phase clock signals include four clock signals whose phases differ successively by 90 degrees. However, in a high-frequency environment, due to the impact of other factors such as the process, voltage, or temperature, the phase differences between the internal four-phase clock signals may exhibit significant skew relative to the ideal value.

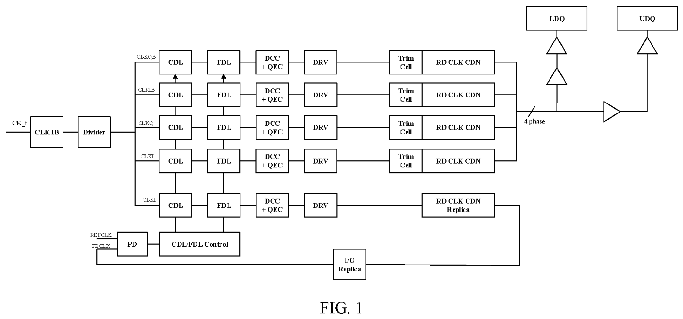

Referring to FIG. 1, the structure of a clock transmission circuit is shown. A clock receiver (clock input buffer, CLK IB) receives an initial clock signal CK_t, and then generates four-phase clock signals CLKI, CLKQ, CLKIB, and CLKQB through a frequency divider (Divider). At present, memories are evolving toward higher speeds. Taking DDR5 as an example, due to increased speed and process limitations, a high-speed clock signal at the interface needs to be converted into a low-speed clock signal inside. Therefore, the phases of CLKI, CLKQ, CLKIB, and CLKQB differ successively by 90 degrees, and their frequencies are half of the frequency of the initial clock signal CK_t. Subsequently, the four-phase clock signals CLKI, CLKQ, CLKIB, and CLKQB respectively enter four adjustable delay lines. Each adjustable delay line includes a coarse delay line (coarse delay line, CDL), a fine delay line (fine delay line, FDL), a duty cycle correcting circuit (duty cycle corrector, DCC), a quadrant error correcting circuit (quadrant error corrector, QEC), and a driver (driver, DRV). Then, the four-phase clock signals are transmitted to an output port area respectively through four read clock distribution networks (read clock distribution networks, RD CLK CDNs) for sampling processing of a data signal DQ. In the figure, the output port area is shown as LDQ and UDQ. LDQ represents the output port area for low-bit data, while UDQ represents the output port area for high-bit data. The delay locked loop further includes an adjustable delay line replica. The adjustable delay line replica is configured to emulate delays of the above adjustable delay lines. The adjustable delay line replica receives CLKI and also includes the same CDL, FDL, DCC+QEC, and DRV modules described above. The clock signal output from the adjustable delay line replica passes through a read clock distribution network replica (read clock distribution network replica, RD CLK CDN Replica) to emulate the delay of the read clock distribution network. The clock signal output from the read clock distribution network replica passes through an input/output emulation circuit (input/output replica, I/O Replica) to generate a feedback clock signal FBCLK. A phase detector (phase detector, PD) compares the phases of a reference clock signal REFCLK and the feedback clock signal FBCLK, and then controls delays of CDL and FDL through a delay control module (CDL/FDL Control), such that a final phase difference between the reference clock signal REFCLK and the feedback clock signal FBCLK is approximately 0, and DLL reaches a locked state. Ideally, when DLL is locked, rising edges of the reference clock signal REFCLK and the feedback clock signal FBCLK are aligned, and the phase difference between the reference clock signal and the feedback clock signal is equal to 0. However, in practice, it may be considered that DLL reaches the locked state as long as the phase difference between REFCLK and FBCLK is approximately 0 within an allowable error range. CLKI may be selected as the reference clock signal REFCLK. The phase differences between the four-phase clock signals transmitted to the output port area should ideally be 90 degrees, that is, the target value is 90 degrees. However, due to the impact of other factors such as the process, voltage, and temperature, it is difficult to achieve consistent delays of the four transmission paths. CLKI, CLKQ, CLKIB, and CLKQB generated by the frequency divider, even if their phases differ successively by 90 degrees, may exhibit a phase difference that deviates from 90 degrees when transmitted to the output port area. In one aspect, a quadrant error correcting circuit (quadrant error corrector, QEC) may be configured to adjust the phase differences between the four-phase clock signals. In another aspect, an adjustment unit is provided in each read clock distribution network, and the adjustment unit is a delay unit controlled by a fuse. After mass production of the chips, extensive tests are performed by testing personnel. Corresponding fuses are blown according to the phase information of the tested four-phase clock signals to select corresponding delay levels, thereby achieving the purpose of calibrating the phase differences between the four-phase clock signals. This method requires significant test time and cannot ensure that the phase differences between the four-phase clock signals still remain at the target value when the operating environment of the memory changes subsequently, which is not beneficial for the generation of a data strobe signal DQS and the sampling processing of the data signal DQ.

Based on this, the embodiments of the present disclosure provide a clock transmission circuit. The clock transmission circuit is applied to a memory and includes: a first clock distribution network, a second clock distribution network, and a phase calibration module. The first clock distribution network is configured to receive a first input clock signal, transmit the first input clock signal to an output port area of the memory, and output a first target clock signal. The second clock distribution network is configured to receive a second input clock signal, transmit the second input clock signal to the output port area of the memory, and output a second target clock signal. The phase difference between the second input clock signal and the first input clock signal is a preset value when the memory is in a normal operating mode; the second input clock signal is in phase with the first input clock signal when the memory is in a calibration mode. The phase calibration module is configured to receive the first target clock signal and the second target clock signal and output, according to the phase difference between the first target clock signal and the second target clock signal, a first phase calibration code when the memory is in the calibration mode. The first phase calibration code is used to adjust the delay of the second clock distribution network; the phase difference between the first target clock signal and the second target clock signal is less than a preset threshold when calibration is completed. As such, when the memory is in the calibration mode, the first clock distribution network and the second clock distribution network transmit in-phase clock signals, and the delay of the second clock distribution network is adjusted according to the phase difference between the transmitted signals, thereby matching the delay of the first clock distribution network with the delay of the second clock distribution network. In this way, when the memory operates normally, the skew in the phase difference between the first target clock signal and the second target clock signal relative to the target value can be reduced, which is beneficial for data transmission. In addition, the setting of the calibration mode can also shorten the test time.

The embodiments of the present disclosure are described in detail below with reference to the drawings.

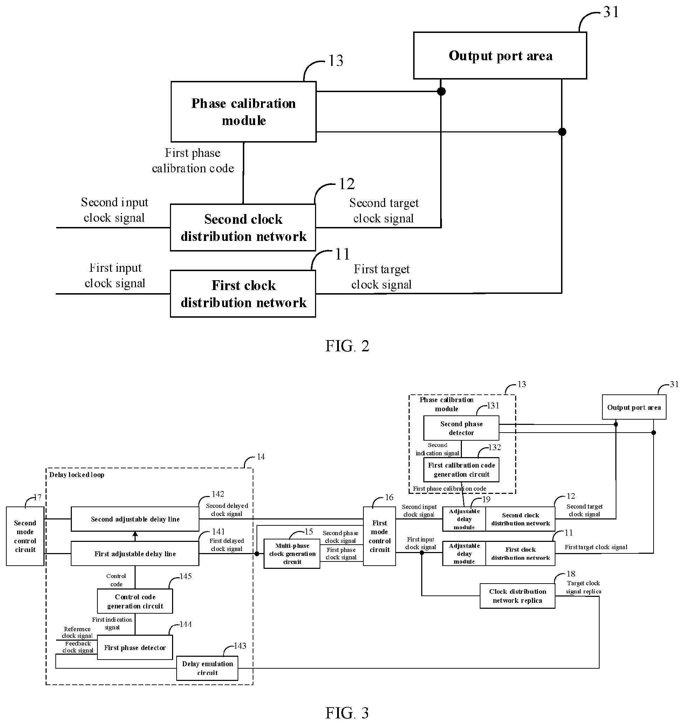

In an embodiment of the present disclosure, referring to FIG. 2, a schematic structural diagram of a clock transmission circuit 10 provided according to an embodiment of the present disclosure is shown. As shown in FIG. 2, the clock transmission circuit 10 includes:
a first clock distribution network 11, which is configured to receive a first input clock signal, transmit the first input clock signal to an output port area 31 of the memory, and output a first target clock signal;
a second clock distribution network 12, which is configured to receive a second input clock signal, transmit the second input clock signal to the output port area 31 of the memory, and output a second target clock signal, where the phase difference between the second input clock signal and the first input clock signal is a preset value when the memory is in a normal operating mode, and the second input clock signal is in phase with the first input clock signal when the memory is in a calibration mode; and
a phase calibration module 13, which is configured to receive the first target clock signal and the second target clock signal and output, according to the phase difference between the first target clock signal and the second target clock signal, a first phase calibration code when the memory is in the calibration mode, where the first phase calibration code is used to adjust the delay of the second clock distribution network, and the phase difference between the first target clock signal and the second target clock signal is less than a preset threshold when calibration is completed.

It should be noted that the clock transmission circuit 10 of the embodiments of the present disclosure may be applied, but without limitation, to memories (such as a DRAM or an SDRAM). In addition, in other analog circuits/digital circuits, such as a controller and a processor, a set of clock signals with different phases may be generated by the clock transmission circuit 10 provided according to the embodiments of the present disclosure.

The first clock distribution network 11 and the second clock distribution network 12 respectively transmit the first input clock signal and the second input clock signal to the output port area 31 of the memory, and output the first target clock signal and the second target clock signal for subsequent generation of the data strobe signal DQS and sampling processing of the data signal DQ. The output port area 31 refers to a relevant circuit area for data output that is arranged near a data pin (DQ Pad) in the memory. The circuit area includes circuits such as a data DQ sampling circuit and an output driving circuit.

When the memory is in the normal operating mode, the phase difference between the second input clock signal and the first input clock signal is the preset value. In some examples, the preset value may be 90 degrees, 180 degrees, or 270 degrees. Ideally, the phase difference between the second target clock signal and the first target clock signal should be equal to the target value, that is, equal to the preset value. However, in practice, due to the impact of other factors such as the process, voltage, and temperature, delays of the uncalibrated first clock distribution network 11 and the uncalibrated second clock distribution network 12 are inconsistent, resulting in the deviation of the phase difference between the second target clock signal and the first target clock signal from the target value, that is, from the preset value.

When the memory is in the calibration mode, the first input clock signal entering the first clock distribution network 11 is in phase with the second input clock signal entering the second clock distribution network 12, and the phase calibration module 13 outputs the first phase calibration code according to the phase difference between the first target clock signal and the second target clock signal, thereby adjusting the delay of the second clock distribution network. When the calibration is completed, the delay of the first clock distribution network 11 is matched and consistent with the delay of the second clock distribution network 12. Ideally, the first target clock signal should also be in phase with the second target clock signal. In practice, when the phase difference between the first target clock signal and the second target clock signal is less than the preset threshold, it may be considered that the calibration is completed. The preset threshold may be set according to the operating environment and actual requirements of the memory, as long as the accuracy of data sampling and transmission can be ensured when the memory operates.

When the calibration is completed, the phase difference between the first target clock signal and the second target clock signal is less than the preset threshold. In this case, the calibrated memory returns to the normal operating mode, the phase difference between the second input clock signal and the first input clock signal is the preset value, and the difference between the phase difference between the second target clock signal and the first target clock signal and the target value should also be less than the preset threshold. In this way, when the memory operates normally, the skew in the phase difference between the first target clock signal and the second target clock signal relative to the target value can be reduced, which is beneficial for subsequent generation of the data strobe signal DQS and sampling processing of the data signal DQ. In addition, the setting of the calibration mode can also shorten the test time.

It should be understood that in the present disclosure, references to phase differences and in-phase conditions allow a certain error. That is, when the memory is in the normal operating mode, the phase difference between the second input clock signal and the first input clock signal is equal to the preset value within the allowable error range. When the memory is in the calibration mode, the second input clock signal is in phase with the first input clock signal within the allowable error range. Subsequent related references to phase values, signal edge alignment, or signal waveform identity are all meant to be within the allowable error range.

In some embodiments, as shown in FIG. 3, the clock transmission circuit 10 further includes:
a delay locked loop 14, where the delay locked loop 14 at least includes a first adjustable delay line 141, where the first adjustable delay line 141 receives a first clock signal and a control code, performs delay processing on the first clock signal based on the control code, and outputs a first delayed clock signal; and
a multi-phase clock generation circuit 15, which is electrically connected to the first adjustable delay line 141 and configured to: receive the first delayed clock signal and generate, based on the first delayed clock signal, at least a first phase clock signal and a second phase clock signal when the operating frequency of the memory is greater than or equal to a preset frequency, where the first phase clock signal is in phase with the first delayed clock signal, and the phase difference between the second phase clock signal and the first phase clock signal is the preset value; and be disabled when the operating frequency of the memory is less than the preset frequency.

When the operating frequency of the memory is greater than or equal to the preset frequency, the multi-phase clock generation circuit 15 generates, based on the first delayed clock signal, at least the first phase clock signal and the second phase clock signal. The first phase clock signal is in phase with the first delayed clock signal, and the phase difference between the second phase clock signal and the first phase clock signal is the preset value. In some examples, the preset value may be 90 degrees, 180 degrees, or 270 degrees. The multi-phase clock generation circuit may be a four-phase clock generation circuit and further generates a third phase clock signal and a fourth phase clock signal. The phases of the first phase clock signal, the second phase clock signal, the third phase clock signal, and the fourth phase clock signal differ successively by 90 degrees. When the memory operates at high speed, the adjustable delay line consumes a large amount of power. Therefore, by using only one adjustable delay line and the multi-phase clock generation circuit to generate the multi-phase clock signals, clock transmission paths can be reduced, circuit power consumption can be lowered, and power supply noise can be reduced, thereby reducing clock jitter and enhancing the quality of the clock signals. When the operating frequency of the memory is less than the preset frequency, the multi-phase clock generation circuit 15 is disabled, thereby further reducing circuit power consumption.

It can be understood that the operating frequency of the memory is equal to the clock frequency of the initial clock signal CK_t received by the memory. The above preset frequency may be set to a required value according to actual scenarios. For example, in DDR5, the preset frequency may be set to 5.6 Gbps. In some embodiments, the multi-phase clock generation circuit 15 may be an analog phase generator (analog phase generator, APG). The APG may generate the first phase clock signal, the second phase clock signal, the third phase clock signal, and the fourth phase clock signal, and the phases of these clock signals differ successively by 90 degrees from each other. However, the APG can only operate in a specific frequency band, and cannot cover a sufficiently wide operating frequency band. For example, when designed to operate at a high frequency, the APG may not be able to generate the correct four-phase clock signals at a low frequency. Therefore, the setting of the preset frequency also needs to take into account the operating frequency band of the multi-phase clock generation circuit 15 to ensure that the multi-phase clock generation circuit 15 can operate normally when the operating frequency of the memory is greater than or equal to the preset frequency.

In some embodiments, as shown in FIG. 3, the clock transmission circuit 10 further includes:
a first mode control circuit 16, which is electrically connected to the multi-phase clock generation circuit 15, the first clock distribution network 11, and the second clock distribution network 12, and configured to: receive the first phase clock signal and the second phase clock signal; transmit the first phase clock signal to the first clock distribution network 11 as the first input clock signal and transmit the second phase clock signal to the second clock distribution network 12 as the second input clock signal when the operating frequency of the memory is greater than or equal to the preset frequency and the memory is in the normal operating mode; and transmit the first phase clock signal to the first clock distribution network 11 and the second clock distribution network 12 as both the first input clock signal and the second input clock signal when the operating frequency of the memory is greater than or equal to the preset frequency and the memory is in the calibration mode.

When the operating frequency of the memory is greater than or equal to the preset frequency and the memory is in the normal operating mode, the first mode control circuit 16 transmits the first phase clock signal to the first clock distribution network 11 and transmits the second phase clock signal to the second clock distribution network 12, thereby ensuring that the phase difference between the second input clock signal and the first input clock signal is the preset value. When the operating frequency of the memory is greater than or equal to the preset frequency and the memory is in the calibration mode, the first mode control circuit 16 transmits the first phase clock signal to both the first clock distribution network 11 and the second clock distribution network 12, thereby ensuring that the second input clock signal is in phase with the first input clock signal. It can be understood that the first mode control circuit 16 may also transmit the second phase clock signal to both the first clock distribution network 11 and the second clock distribution network 12, and this may also ensure that the second input clock signal is in phase with the first input clock signal.

The first mode control circuit 16 may be implemented by using a multiplexer Mux. A first input terminal of the multiplexer receives the first phase clock signal, a second input terminal of the multiplexer receives the second phase clock signal, a first output terminal of the multiplexer is connected to the first clock distribution network 11, a second output terminal of the multiplexer is connected to the second clock distribution network 12, and a control terminal of the multiplexer receives a mode control signal. The mode control signal indicates whether the memory is in the normal operating mode or in the calibration mode. The multiplexer always transmits the signal from the first input terminal to the first output terminal, and, in response to the mode control signal, selects either the signal from the first input terminal or the second input terminal to transmit to the second output terminal.

In some embodiments, as shown in FIG. 3, the delay locked loop 14 further includes a second adjustable delay line 142. The second adjustable delay line 142 is configured to: receive the second clock signal when the operating frequency of the memory is less than the preset frequency and the memory is in the normal operating mode; receive the first clock signal when the operating frequency of the memory is less than the preset frequency and the memory is in the calibration mode; perform the delay processing on the received signal based on the control code and output a second delayed clock signal; and be disabled when the operating frequency of the memory is greater than or equal to the preset frequency.

When the operating frequency of the memory is greater than or equal to the preset frequency, the second adjustable delay line 142 is disabled, and the multi-phase clock signals are generated by relying on the first adjustable delay line 141 and the multi-phase clock generation circuit 15, such that clock transmission paths can be reduced, circuit power consumption can be lowered, and power supply noise can be reduced, thereby reducing clock jitter and enhancing the quality of the clock signals.

When the operating frequency of the memory is less than the preset frequency and the memory is in the normal operating mode, the second adjustable delay line 142 receives and transmits the second clock signal, the phase difference between the second clock signal and the first clock signal is the preset value, the multi-phase clock generation circuit 15 is disabled, and two clock signals with different phases are transmitted through the first adjustable delay line 141 and the second adjustable delay line 142. When the operating frequency of the memory is less than the preset frequency and the memory is in the calibration mode, the second adjustable delay line 142 receives and transmits the first clock signal, and both the first adjustable delay line 141 and the second adjustable delay line 142 transmit the first clock signal for phase calibration.

In some embodiments, the first mode control circuit 16 is further electrically connected to the second adjustable delay line 142, receives the second delayed clock signal, and transmits the first delayed clock signal to the first clock distribution network 11 as the first input clock signal and transmits the second delayed clock signal to the second clock distribution network 12 as the second input clock signal when the operating frequency of the memory is less than the preset frequency.

It can be understood that, when the operating frequency of the memory is less than the preset frequency, the first mode control circuit 16 does not distinguish between the normal operating mode and the calibration mode, and always transmits the first delayed clock signal output by the first adjustable delay line 141 to the first clock distribution network 11 and transmits the second delayed clock signal output by the second adjustable delay line 142 to the second clock distribution network 12.

In some embodiments, as shown in FIG. 3, the clock transmission circuit 10 further includes:
a second mode control circuit 17, which is electrically connected to the first adjustable delay line 141 and the second adjustable delay line 142 and configured to: transmit the first clock signal to the first adjustable delay line 141 and transmit the second clock signal to the second adjustable delay line 142 when the operating frequency of the memory is less than the preset frequency and the memory is in the normal operating mode; transmit the first clock signal to both the first adjustable delay line 141 and the second adjustable delay line 142 when the operating frequency of the memory is less than the preset frequency and the memory is in the calibration mode; and transmit the first clock signal to the first adjustable delay line 141 when the operating frequency of the memory is greater than or equal to the preset frequency.

When the operating frequency of the memory is less than the preset frequency and the memory is in the normal operating mode, the first clock signal is transmitted to the first adjustable delay line 141, and the second clock signal is transmitted to the second adjustable delay line 142. The phase difference between the first clock signal and the second clock signal is the preset value, such that clock signals with different phases are transmitted on two transmission paths. When the operating frequency of the memory is less than the preset frequency and the memory is in the calibration mode, the first clock signal is transmitted to both the first adjustable delay line 141 and the second adjustable delay line 142, such that in-phase clock signals are transmitted on the two transmission paths for phase calibration.

When the operating frequency of the memory is greater than or equal to the preset frequency, the first clock signal is transmitted to the first adjustable delay line 141. In this case, the second clock signal may or may not be transmitted to the second adjustable delay line 142. Since the second adjustable delay line 142 is disabled in this case, no transmission is performed regardless of whether the second clock signal is received.

Several cases will be described below with reference to Table 1.

**Table 1**

| **Operating frequency** | **Mode** | **First adjustable delay line** | **Second adjustable delay line** | **First clock distribution network** | **Second clock distribution network** |
|---|---|---|---|---|---|
| Greater than or equal to the preset frequency | Normal operating | First clock signal | Disabled | First phase clock signal | Second phase clock signal |
| | Calibration | First clock signal | Disabled | First phase clock signal | First phase clock signal |
| Less than the preset frequency | Normal operating | First clock signal | Second clock signal | First delayed clock signal | Second delayed clock signal |
| | Calibration | First clock signal | First clock signal | First delayed clock signal | Second delayed clock signal |

Case 1: When the operating frequency of the memory is greater than or equal to the preset frequency and the memory is in the normal operating mode, the second mode control circuit 17 transmits the first clock signal to the first adjustable delay line 141; the second adjustable delay line 142 is disabled, and the first adjustable delay line 141 performs the delay processing on the first clock signal based on the control code and outputs the first delayed clock signal; the multi-phase clock generation circuit 15 generates the first phase clock signal and the second phase clock signal based on the first delayed clock signal; the first mode control circuit 16 transmits the first phase clock signal to the first clock distribution network 11 and transmits the second phase clock signal to the second clock distribution network 12; the first clock distribution network 11 and the second clock distribution network 12 respectively transmit the first phase clock signal and the second phase clock signal to the output port area for sampling processing of the data signal DQ.

Case 2: When the operating frequency of the memory is greater than or equal to the preset frequency and the memory is in the calibration mode, the second mode control circuit 17 transmits the first clock signal to the first adjustable delay line 141; the second adjustable delay line 142 is disabled, and the first adjustable delay line 141 performs the delay processing on the first clock signal based on the control code and outputs the first delayed clock signal; the multi-phase clock generation circuit 15 generates the first phase clock signal and the second phase clock signal based on the first delayed clock signal; the first mode control circuit 16 transmits the first phase clock signal to both the first clock distribution network 11 and the second clock distribution network 12. In this case, the first phase clock signal is transmitted in both the first clock distribution network 11 and the second clock distribution network 12 for phase calibration.

Case 3: When the operating frequency of the memory is less than the preset frequency and the memory is in the normal operating mode, the second mode control circuit 17 transmits the first clock signal to the first adjustable delay line 141 and transmits the second clock signal to the second adjustable delay line 142; the first adjustable delay line 141 performs the delay processing on the first clock signal based on the control code and outputs the first delayed clock signal; the second adjustable delay line 142 performs the delay processing on the second clock signal based on the control code and outputs the second delayed clock signal; the multi-phase clock generation circuit 15 is disabled; the first mode control circuit 16 transmits the first delayed clock signal to the first clock distribution network 11 and transmits the second delayed clock signal to the second clock distribution network 12; the first clock distribution network 11 and the second clock distribution network 12 respectively transmit the first delayed clock signal and the second delayed clock signal to the output port area for sampling processing of the data signal DQ.

Case 4: When the operating frequency of the memory is less than the preset frequency and the memory is in the calibration mode, the second mode control circuit 17 transmits the first clock signal to both the first adjustable delay line 141 and the second adjustable delay line 142; both the first adjustable delay line 141 and the second adjustable delay line 142 perform the delay processing on the first clock signal based on the control code and respectively output the first delayed clock signal and the second delayed clock signal; the multi-phase clock generation circuit 15 is disabled; the first mode control circuit 16 transmits the first delayed clock signal to the first clock distribution network 11 and transmits the second delayed clock signal to the second clock distribution network 12. In this case, signals transmitted in the first clock distribution network 11 and the second clock distribution network 12 are all from the first clock signal for phase calibration.

As can be learned from the foregoing analysis, with the configurations of the first mode control circuit 16 and the second mode control circuit 17 in different cases, the first clock distribution network 11 and the second clock distribution network 12 can transmit in-phase clock signals regardless of whether the memory operates at a high frequency or a low frequency in the calibration mode. The delay of the second clock distribution network 12 is adjusted according to the phase difference between the transmitted signals, thereby matching the delay of the first clock distribution network 11 with the delay of the second clock distribution network 12. In this way, when the memory operates normally, the skew in the phase difference between the first target clock signal and the second target clock signal relative to the target value can be reduced, which is beneficial for data transmission. In addition, the setting of the calibration mode can also shorten the test time. Meanwhile, during normal operation, only the first adjustable delay line 141 and the multi-phase clock generation circuit 15 are enabled to generate the multi-phase clock signals, such that clock transmission paths can be reduced, circuit power consumption can be lowered, and power supply noise can be reduced, thereby reducing clock jitter and enhancing the quality of the clock signals.

Both the first mode control circuit 16 and the second mode control circuit 17 may be implemented by using one or more multiplexers Mux. The control logic between the input terminal and the output terminal of the multiplexer may be set according to Table 1 and the analysis logic of the several cases described above, which will not be repeated here.

In some embodiments, the first adjustable delay line 141 and the second adjustable delay line 142 share the same circuit structure. In some embodiments, the first clock distribution network 11 and the second clock distribution network 12 share the same circuit structure. In this way, the delays between different paths can be matched as closely as possible. When the memory operates normally, the skew in the phase difference between the first target clock signal and the second target clock signal relative to the target value is reduced. When the memory is in the calibration mode, this is also beneficial for shortening the calibration time.

In some embodiments, the first adjustable delay line 141 and the second adjustable delay line 142 each include a coarse delay line CDL, a fine delay line FDL, and a driver DRV.

The coarse delay line CDL and the fine delay line FDL receive the control code and adjust the delay time in response to the control code. The adjustment step size of the coarse delay line CDL is larger than the adjustment step size of the fine delay line FDL. The first adjustable delay line 141 and the second adjustable delay line 142 mainly rely on the coarse delay line CDL and the fine delay line FDL to adjust their own delay time. The driver DRV is generally located at the ends of the first adjustable delay line 141 and the second adjustable delay line 142 and configured to enhance the driving capability of an output signal, thereby enhancing the quality of a clock signal transmitted to a subsequent circuit. The driver DRV may consist of an even number of inverters, and the size of the inverter may be set according to the length of a subsequent transmission path and the load.

In some embodiments, the first adjustable delay line 141 and the second adjustable delay line 142 further include a duty cycle correcting circuit DCC. Since the clock signal is transmitted over a long distance, there may be offset in the rising edge and the falling edge, causing duty cycle distortion and phase offset. The duty cycle correcting circuit DCC is configured to adjust the duty cycle of the clock signal, such that the duty cycle of the clock signal is as close to 50% as possible, which is beneficial for accurate sampling of the subsequent data signal DQ.

In some embodiments, as shown in FIG. 3, the clock transmission circuit 10 further includes:
a clock distribution network replica 18, which receives the first input clock signal, emulates the delay of the first clock distribution network, and outputs a target clock signal replica.

It can be understood that the clock distribution network replica 18 directly receives the first input clock signal output by the first mode control circuit 16 to emulate the delay of the first clock distribution network, instead of receiving the first delayed clock signal or the first phase clock signal, such that there is no need to emulate delays of the multi-phase clock generation circuit 15 and the first mode control circuit 16, thereby simplifying the circuit and reducing circuit power consumption.

In some embodiments, as shown in FIG. 3, the delay locked loop 14 further includes:
a delay emulation circuit 143, which receives the target clock signal replica and is configured to emulate delays of a clock input path and a clock output path in the memory and output a feedback clock signal, where the clock input path includes a clock receiver and a frequency divider, and the clock output path includes an output driving circuit;
a first phase detector 144, which is electrically connected to the delay emulation circuit 143 and configured to receive the feedback clock signal and a reference clock signal and output, based on a phase sequence of the feedback clock signal and the reference clock signal, a first indication signal; and
a control code generation circuit 145, which is electrically connected to the first phase detector 144, and configured to adjust and output the control code based on the first indication signal.

It should be noted that the delay emulation circuit 143 emulates the delays of the clock input path and the clock output path in the memory. That is, the delay of the delay emulation circuit 143 is as close to the delays of the clock input path and the clock output path as possible, so as to reduce the phase error during DLL locking. The clock input path includes the clock receiver CLK IB that receives the initial clock signal CK_t and the frequency divider Divider, and the clock output path includes the output driving circuit that outputs the data signal DQ and the data strobe signal DQS.

The first phase detector 144 receives the feedback clock signal and the reference clock signal. The reference clock signal may be the first clock signal, or may be a signal whose phase waveform is consistent with that of the first clock signal. The first phase detector 144 compares the phases of the reference clock signal and the feedback clock signal and then controls delays of the first adjustable delay line and the second adjustable delay line through the control code generation circuit 145. Under the action of a closed-loop feedback mechanism, the final phase difference between the reference clock signal and the feedback clock signal is approximately 0, and DLL reaches the locked state. Ideally, when DLL is locked, the rising edges of the reference clock signal and the feedback clock signal are aligned, and the phase difference between the reference clock signal and the feedback clock signal is equal to 0. However, in practice, it may be considered that DLL reaches the locked state as long as the phase difference between the reference clock signal and the feedback clock signal is approximately 0 within the allowable error range.

In some embodiments, the delay locked loop has completed phase locking before the memory enters the calibration mode. In other words, only after DLL is locked can the memory enter the calibration mode to perform calibration on the phase difference. Otherwise, when the DLL locking and the calibration are performed simultaneously, the delays of the first adjustable delay line 141, the second adjustable delay line 142, and the second clock distribution network 12 may all be adjusted simultaneously. This may result in interference with each other, increases the locking time and the calibration time, and may even cause locking or calibration failure. Before the memory enters the calibration mode, it is ensured that DLL has been locked, which is beneficial for ensuring a successful calibration on the phase difference and shortening the calibration time.

In some embodiments, as shown in FIG. 3, the phase calibration module 13 includes:
a second phase detector 131, which receives the first target clock signal and the second target clock signal and outputs, based on a phase sequence of the first target clock signal and the second target clock signal, a second indication signal; and
a first calibration code generation circuit 132, which is electrically connected to the second phase detector 131 and configured to adjust and output the first phase calibration code based on the second indication signal.

It should be noted that in the calibration mode, the second phase detector 131 receives the first target clock signal and the second target clock signal and compares the phase relationship between the first target clock signal and the second target clock signal, and the output second indication signal indicates that the first target clock signal leads or lags behind the second target clock signal. If the first target clock signal leads the second target clock signal, the first phase calibration code output by the first calibration code generation circuit 132 may shorten the delay of the second clock distribution network 12; if the first target clock signal lags behind the second target clock signal, the first phase calibration code output by the first calibration code generation circuit 132 may extend the delay of the second clock distribution network 12. Under the action of the closed-loop feedback mechanism, if a final phase difference between the first target clock signal and the second target clock signal is less than the preset threshold, it may be considered that the calibration is completed. It can be understood that the first phase calibration code may also adjust the delay of the first clock distribution network according to the phase relationship between the first target clock signal and the second target clock signal, as long as the phase difference is less than the preset threshold after the calibration is completed. Since the first input clock signal and the second input clock signal respectively received by the first clock distribution network 11 and the second clock distribution network 12 are in phase in the calibration mode, the operation of detecting and aligning the first target clock signal and the second target clock signal by the phase calibration module 13 is simpler and more accurate than the adjustment based on the target value in the normal operating mode.

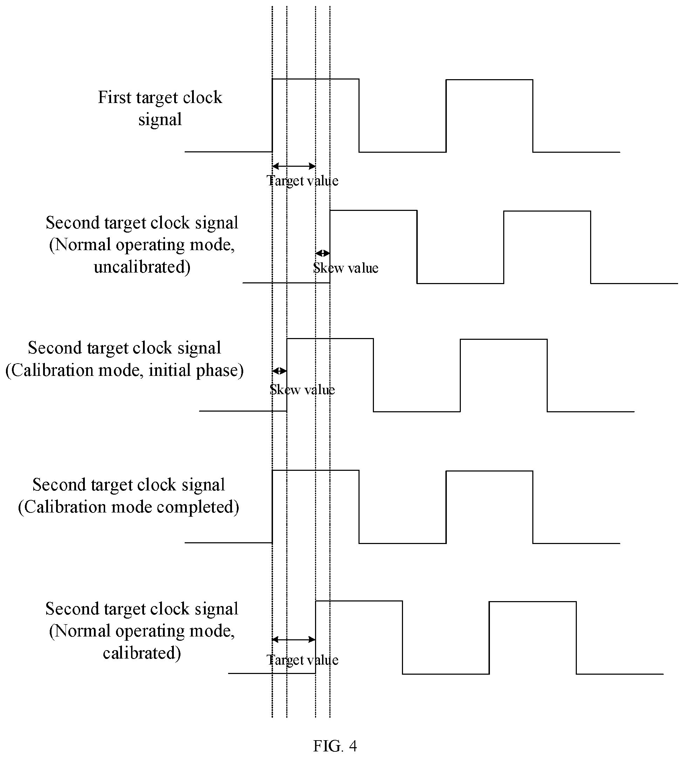

Referring to FIG. 4, a waveform diagram of the first target clock signal and the second target clock signal is shown. When the memory is in the normal operating mode and uncalibrated, the first clock distribution network 11 and the second clock distribution network 12 respectively receive the first input clock signal and the second input clock signal, and the phase difference between the first input clock signal and the second input clock signal is the preset value. After the transmission, a significant skew value remains in the phase difference between the output first target clock signal and second target clock signal relative to the target value, i.e., the preset value. After the memory enters the calibration mode, the first input clock signal and the second input clock signal respectively received by the first clock distribution network 11 and the second clock distribution network 12 are in phase. After the transmission, the phase difference between the output first target clock signal and second target clock signal is still the above skew value in an initial calibration phase. During the calibration, the first phase calibration code adjusts the delay of the second clock distribution network. When the calibration is completed, ideally, the second target clock signal is aligned with the first target clock signal. In practice, it may be considered that the calibration is completed as long as the phase difference between the second target clock signal and the first target clock signal is less than the preset threshold. After the calibration is completed, when the memory returns to the normal operating mode, the skew in the phase difference between the second target clock signal and the first target clock signal relative to the target value should also be less than the preset threshold.

In some embodiments, as shown in FIG. 3, the second clock distribution network 12 includes an adjustable delay module 19. The adjustable delay module 19 receives the first phase calibration code and adjusts its own delay in response to the first phase calibration code. It can be understood that the second clock distribution network 12 mainly relies on the adjustable delay module to adjust its own delay. The first clock distribution network 11 may also include an adjustable delay module, and the delay of the adjustable delay module is set to a default value. In some examples, the first phase calibration code is used to adjust the delay of the adjustable delay module in the first clock distribution network, and the adjustable delay module in the second clock distribution network 12 is set to a default value.

In some embodiments, the adjustable delay module 19 includes a plurality of delay units (not shown in the figure). Each delay unit is enabled or disabled in response to one bit in the first phase calibration code. For example, the adjustable delay module 19 includes N delay units, where N is an integer greater than 1, and the delay of each delay unit is T. The first phase calibration code includes N bits in total. Each bit is used to control the enabling or disabling of one delay unit. When the delay unit is enabled, it indicates that the delay unit is connected to the second clock distribution network 12, and its delay T is included in the delay of the second clock distribution network 12. When the delay unit is disabled, it indicates that the delay unit is not connected to the second clock distribution network 12 and is short-circuited, and its delay T is not included in the delay of the second clock distribution network 12. If A delay units are enabled, where A is an integer greater than or equal to 0 and less than or equal to N, the delay of the adjustable delay module is A*T. In some examples, delays of the plurality of delay units may also be set to gradient values T, 2T, 4T, 8T, etc., separately, which can expand the adjustable delay range.

In some embodiments, the first calibration code generation circuit 132 includes a shift register (not shown in the figure). The shift register is configured to receive the second indication signal, perform a left shift or a right shift according to the second indication signal, and output the first phase calibration code. For example, the first phase calibration code includes 8 bits, and the initial value is 00001111. The value 1 indicates that the delay unit is enabled, and the value 0 indicates that the delay unit is disabled. In this case, four delay units are initially enabled. If the first target clock signal leads the second target clock signal, the second indication signal output by the second phase detector instructs the shift register to shift right with 0 padding at the most significant bit, and as a result, the first phase calibration code changes to 00000111, three delay units are controlled to be enabled, and thereby the delay of the second clock distribution network 12 is shortened. If the first target clock signal lags behind the second target clock signal, the second instruction signal output by the second phase detector instructs the shift register to shift left with 1 padding at the least significant bit, and as a result, the first phase calibration code changes to 00011111, five delay units are controlled to be enabled, and thereby the delay of the second clock distribution network 12 is extended. In some examples, the delay of the adjustable delay module in the first clock distribution network may be set to a default value. The default value is a median value of an adjustable range of the adjustable delay module. The first phase calibration code output by the shift register is used to adjust the delay of the adjustable delay module in the second clock distribution network. The delay of the adjustable delay module in the second clock distribution network may also be set to a default value. The default value is a median value of the adjustable range of the adjustable delay module. The first phase calibration code output by the shift register is used to adjust the delay of the adjustable delay module in the first clock distribution network. The number of bits of the shift register may be set in combination with the delay of the delay unit according to requirements.

In some embodiments, the clock transmission circuit 10 further includes a register (not shown in the figure). The register is configured to: store the first phase calibration code after the calibration mode is completed; and transmit the first phase calibration code to the second clock distribution network 12 when the memory is in the normal operating mode.

In some embodiments, the phase calibration module 13 stops operating after the calibration mode is completed.

After the calibration mode is completed, the phase calibration module 13 transmits the first phase calibration code to the register, the register stores the first phase calibration code, and the register transmits the first phase calibration code when in the normal operating mode. As such, this not only ensures that the skew in the phase difference between the second target clock signal and the first target clock signal relative to the target value is less than the preset threshold in the normal operating mode, but also allows the phase calibration module 13 to stop operating, thereby reducing circuit power consumption.

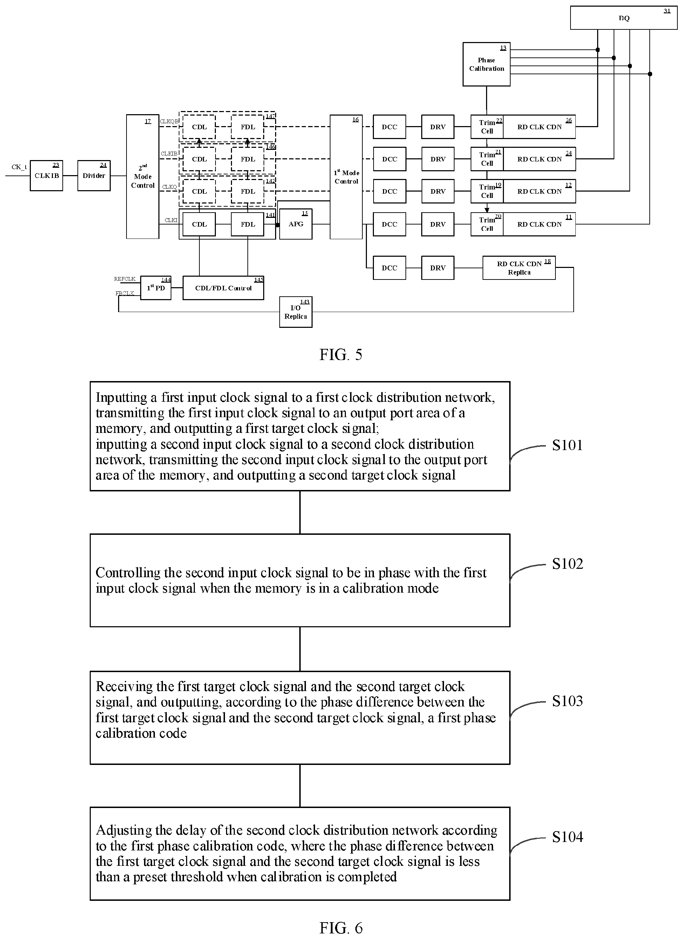

In some embodiments, as shown in FIG. 5, the clock transmission circuit 10 further includes:
a third clock distribution network 24, which is configured to receive a third input clock signal, transmit the third input clock signal to the output port area 31 (shown as DQ in FIG.5) of the memory, and output a third target clock signal, where the phase difference between the third input clock signal and the second input clock signal is 90 degrees when the memory is in the normal operating mode, and the third input clock signal is in phase with the first input clock signal when the memory is in the calibration mode; and
a fourth clock distribution network 26, which is configured to receive a fourth input clock signal, transmit the fourth input clock signal to the output port area 31 of the memory, and output a fourth target clock signal, where the phase difference between the fourth input clock signal and the third input clock signal is 90 degrees when the memory is in the normal operating mode, and the fourth input clock signal is in phase with the first input clock signal when the memory is in the calibration mode.

The phase calibration module 13 is further configured to: receive the third target clock signal and the fourth target clock signal and output, according to the phase difference between the third target clock signal and the first target clock signal, a second phase calibration code when the memory is in the calibration mode, where the second phase calibration code is used to adjust the delay of the third clock distribution network 24; and output, according to the phase difference between the fourth target clock signal and the first target clock signal, a third phase calibration code, where the third phase calibration code is used to adjust the delay of the fourth clock distribution network 26. When the calibration is completed, the phase difference between the first target clock signal and the third target clock signal is less than the preset threshold, and the phase difference between the first target clock signal and the fourth target clock signal is less than the preset threshold.

The four clock distribution networks (read clock distribution networks, RD CLK CDNs) are respectively shown as 11, 12, 24, and 26 in FIG. 5. In the normal operating mode, the four clock distribution networks respectively receive the first input clock signal, the second input clock signal, the third input clock signal, and the fourth input clock signal whose phases differ successively by 90 degrees, and transmit the signals to the output port area of the memory for sampling processing of the data signal DQ. In the calibration mode, the four clock distribution networks receive in-phase clock signals. The first phase calibration code is output according to the phase difference between the second target clock signal and the first target clock signal to adjust the delay of the second clock distribution network 12; the second phase calibration code is output according to the phase difference between the third target clock signal and the first target clock signal to adjust the delay of the third clock distribution network 24; the third phase calibration code is output according to the phase difference between the fourth target clock signal and the first target clock signal to adjust the delay of the fourth clock distribution network 26. In this way, when the calibration is completed, the phase differences between the first target clock signal, the second target clock signal, the third target clock signal, and the fourth target clock signal should all be less than the preset threshold. When the memory returns to the normal operating mode, the skew in the phase differences between these target clock signals relative to 90 degrees should also be less than the preset threshold.

In some embodiments, as shown in FIG. 5, the delay locked loop 14 further includes:
a third adjustable delay line 146, which is configured to: receive a third clock signal CLKIB when the operating frequency of the memory is less than the preset frequency and the memory is in the normal operating mode; receive the first clock signal CLKI when the operating frequency of the memory is less than the preset frequency and the memory is in the calibration mode; perform the delay processing on the received signal based on the control code and output a third delayed clock signal; and be disabled when the operating frequency of the memory is greater than or equal to the preset frequency; and
a fourth adjustable delay line 147, which is configured to: receive a fourth clock signal CLKQB when the operating frequency of the memory is less than the preset frequency and the memory is in the normal operating mode; receive the first clock signal CLKI when the operating frequency of the memory is less than the preset frequency and the memory is in the calibration mode; perform the delay processing on the received signal based on the control code and output a fourth delayed clock signal; and be disabled when the operating frequency of the memory is greater than or equal to the preset frequency.

The phases of the first clock signal CLKI, the second clock signal CLKQ, the third clock signal CLKIB, and the fourth clock signal CLKQB differ successively by 90 degrees.

When the operating frequency of the memory is greater than or equal to the preset frequency, the third adjustable delay line 146 and the fourth adjustable delay line 147 are disabled, and the four-phase clock signals are generated by relying on the first adjustable delay line 141 and the multi-phase clock generation circuit 15, such that clock transmission paths can be reduced, circuit power consumption can be lowered, and power supply noise can be reduced, thereby reducing clock jitter and enhancing the quality of the clock signals.

When the operating frequency of the memory is less than the preset frequency and the memory is in the normal operating mode, the first adjustable delay line 141, the second adjustable delay line 142, the third adjustable delay line 146, and the fourth adjustable delay line 147 respectively receive and transmit the first clock signal CLKI, the second clock signal CLKQ, the third clock signal CLKIB, and the fourth clock signal CLKQB. The multi-phase clock generation circuit 15 is disabled, and the four adjustable delay lines respectively transmit the four clock signals whose phases differ successively by 90 degrees. When the operating frequency of the memory is less than the preset frequency and the memory is in the calibration mode, the first adjustable delay line 141, the second adjustable delay line 142, the third adjustable delay line 146, and the fourth adjustable delay line 147 all receive and transmit the first clock signal CLKI for phase calibration.

Referring to FIG. 5, the first adjustable delay line 141, the second adjustable delay line 142, the third adjustable delay line 146, and the fourth adjustable delay line 147 all share the same circuit structure and include a coarse delay line CDL and a fine delay line FDL. The duty cycle correcting circuit DCC and the driver DRV may be located within the four adjustable delay lines or after the first mode control circuit 16. In the figure, an example in which the DCC and the DRV are placed after the first mode control circuit 16 is used. In this way, in the calibration mode, the clock signals received by the four DCCs are all in phase, and the phase skew introduced by the DCC and the DRV may also be corrected in the calibration mode. The second adjustable delay line 142, the third adjustable delay line 146, and the fourth adjustable delay line 147 are represented by dashed boxes, indicating that the second adjustable delay line 142, the third adjustable delay line 146, and the fourth adjustable delay line 147 are disabled when the operating frequency of the memory is greater than or equal to the preset frequency, and are enabled only when the operating frequency of the memory is less than the preset frequency. The first adjustable delay line 141 is represented by a solid box, indicating that the first adjustable delay line is enabled at any operating frequency. In this way, circuit power consumption of the memory during high-frequency operation can be reduced, and power supply noise can be reduced, thereby reducing clock signal jitter.

Still referring to FIG. 5, the first clock distribution network 11, the second clock distribution network 12, the third clock distribution network 24, the fourth clock distribution network 26, and the clock distribution network replica 18 all share the same circuit structure to reduce the delay skew between different paths.

In some embodiments, the multi-phase clock generation circuit 15 is further configured to generate a third phase clock signal and a fourth phase clock signal based on the first delayed clock signal. The phases of the first phase clock signal, the second phase clock signal, the third phase clock signal, and the fourth phase clock signal differ successively by 90 degrees.

The multi-phase clock generation circuit 15 may be an analog phase generator (analog phase generator, APG). When the operating frequency of the memory is greater than or equal to the preset frequency, the multi-phase clock generation circuit further generates the third phase clock signal and the fourth phase clock signal. The phases of the first phase clock signal, the second phase clock signal, the third phase clock signal, and the fourth phase clock signal differ successively by 90 degrees. As such, when the memory operates at high speed, only the first adjustable delay line 11 and the first clock distribution network 12 need to be enabled to transmit the first clock signal CLKI to the APG, and then the required clock signals of four phases are generated for the sampling of the data signal DQ. In this way, circuit power consumption can be greatly reduced, and power supply noise can be reduced, thereby reducing clock jitter.

In some embodiments, the first mode control circuit (1^{st} Mode Control) 16 is further electrically connected to the third adjustable delay line 146 and the fourth adjustable delay line 147 and configured to: receive the third phase clock signal, the fourth phase clock signal, the third delayed clock signal, and the fourth delayed clock signal; transmit the third phase clock signal to the third clock distribution network 24 as the third input clock signal and transmit the fourth phase clock signal to the fourth clock distribution network 26 as the fourth input clock signal when the operating frequency of the memory is greater than or equal to the preset frequency and the memory is in the normal operating mode; transmit the first phase clock signal to the third clock distribution network 24 and the fourth clock distribution network 26 as both the third input clock signal and the fourth input clock signal when the operating frequency of the memory is greater than or equal to the preset frequency and the memory is in the calibration mode; and transmit the third delayed clock signal to the third clock distribution network 24 as the third input clock signal and transmit the fourth delayed clock signal to the fourth clock distribution network 26 as the fourth input clock signal when the operating frequency of the memory is less than the preset frequency.

The second mode control circuit (2^{nd} Mode Control) 17 is further electrically connected to the third adjustable delay line 146 and the fourth adjustable delay line 147 and configured to: transmit the third clock signal CLKIB to the third adjustable delay line 146 and transmit the fourth clock signal CLKQB to the fourth adjustable delay line 147 when the operating frequency of the memory is less than the preset frequency and the memory is in the normal operating mode; and transmit the first clock signal CLKI to both the third adjustable delay line 146 and the fourth adjustable delay line 147 when the operating frequency of the memory is less than the preset frequency and the memory is in the calibration mode.

The first mode control circuit 16 and the second mode control circuit 17 are configured to work in coordination, such that when the operating frequency of the memory is greater than or equal to the preset frequency, the first adjustable delay line 141 receives the first clock signal CLKI, while the other three adjustable delay lines are disabled, and the multi-phase clock generation circuit APG is used to generate the clock signals of four phases. In the normal operating mode, the first mode control circuit 16 respectively transmits the clock signals of four phases to the four clock distribution networks to finally transmit the signals to the output port area 31 for sampling processing of the data signal DQ. In the calibration mode, the first mode control circuit 16 transmits only the first phase clock signal separately to the four clock distribution networks for phase calibration. When the operating frequency of the memory is less than the preset frequency and the memory is in the normal operating mode, the first adjustable delay line 141, the second adjustable delay line 142, the third adjustable delay line 146, and the fourth adjustable delay line 147 respectively receive CLKI, CLKQ, CLKIB, and CLKQB, transmit the signals to the four clock distribution networks, and finally transmit the signals to the output port area 31 for sampling processing of the data signal DQ. When the operating frequency of the memory is less than the preset frequency and the memory is in the calibration mode, the second mode control circuit 17 transmits the first clock signal CLKI to all the four adjustable delay lines, which then transmit the first clock signal to the four clock distribution networks for phase calibration.

As can be learned from the foregoing analysis, with the configurations of the first mode control circuit 16 and the second mode control circuit 17 in different cases, the four clock distribution networks can transmit in-phase clock signals regardless of whether the memory operates at a high frequency or a low frequency in the calibration mode. The delays of the second clock distribution network 12, the third clock distribution network 24, and the fourth clock distribution network 26 are adjusted according to the phase difference between the transmitted signals, thereby matching the delays of the four clock distribution networks. In this way, when the memory operates normally, the skew in the phase differences between the first target clock signal, the second target clock signal, the third target clock signal, and the fourth target clock signal relative to 90 degrees can be reduced, which is beneficial for data transmission. In addition, the setting of the calibration mode can also shorten the test time. Meanwhile, during normal operation, only the first adjustable delay line 141 and the multi-phase clock generation circuit 15 are enabled to generate the four-phase clock signals, such that clock transmission paths can be reduced, circuit power consumption can be lowered, and power supply noise can be reduced, thereby reducing clock jitter and enhancing the quality of the clock signals.

In some embodiments, the clock frequencies of the first clock signal CLKI, the second clock signal CLKQ, the third clock signal CLKIB, and the fourth clock signal CLKQB are half of the clock frequency of an initial clock signal CK_t received by the memory. The clock frequency of the initial clock signal CK_t is equal to the operating frequency of the memory.

As shown in FIG. 5, the clock receiver (clock input buffer, CLK IB) 23 receives the initial clock signal CK_t, and then generates the first clock signal CLKI, the second clock signal CLKQ, the third clock signal CLKIB, and the fourth clock signal CLKQB through the frequency divider (Divider) 24. The clock signals are respectively sent to the four adjustable delay lines for transmission.

In some embodiments, as shown in FIG. 5, the phase calibration module (Phase Calibration) 13 further includes:
a third phase detector, which receives the first target clock signal and the third target clock signal and outputs, based on a phase sequence of the first target clock signal and the third target clock signal, a third indication signal;
a second calibration code generation circuit, which is electrically connected to the third phase detector and configured to adjust and output the second phase calibration code based on the third indication signal;
a fourth phase detector, which receives the first target clock signal and the fourth target clock signal and outputs, based on a phase sequence of the first target clock signal and the fourth target clock signal, a fourth indication signal; and
a third calibration code generation circuit, which is electrically connected to the fourth phase detector and configured to adjust and output the third phase calibration code based on the fourth indication signal.

The third phase detector, the fourth phase detector, the second calibration code generation circuit, and the third calibration code generation circuit are not specifically shown in the figure. The operating principles thereof are similar to those of the second phase detector and the first calibration code generation circuit, which will not be repeated here. The difference lies only in that the second phase calibration code output by the third phase detector and the second calibration code generation circuit is used to calibrate the delay of the third clock distribution network 24, and the third phase calibration code output by the fourth phase detector and the third calibration code generation circuit is used to calibrate the delay of the fourth clock distribution network 26. In this way, three groups of circuits are present, each group includes one phase detector and one calibration code generation circuit, and a total of three groups of phase calibration codes are output to respectively adjust the delays of the second clock distribution network 12, the third clock distribution network 24, and the fourth clock distribution network 26. This approach has the advantage of simultaneous calibration of the four clock distribution networks, that is, simultaneous phase calibration of the first target clock signal and the second target clock signal, the first target clock signal and the third target clock signal, and the first target clock signal and the fourth target clock signal, thereby reducing the calibration time.

In some examples, the third phase detector, the fourth phase detector, the second calibration code generation circuit, and the third calibration code generation circuit may not be needed. The second clock distribution network 12, the third clock distribution network 24, and the fourth clock distribution network 26 are serially calibrated in sequence by using only the second phase detector and the first calibration code generation circuit. This approach has the advantage of saving circuit area, but it requires a long time to complete the calibration for all phase clock signals. Meanwhile, a multiplexer needs to be added to an input terminal of the second phase detector and an output terminal of the first calibration code generation circuit to select to receive one of the second target clock signal, the third target clock signal, and the fourth target clock signal for entering the phase detector and to select the first phase calibration code to adjust the delay of one of the second clock distribution network 12, the third clock distribution network 24, and the fourth clock distribution network 26.

In some examples, each clock distribution network (RD CLK CDN) includes a respective adjustable delay module (Trim Cell) to receive a corresponding phase calibration code to adjust its own delay. The adjustable delay modules in the clock distribution networks all share the same circuit structure, for example, all include N delay units, and the difference lies only in that different quantities of delay units may be enabled for calibration in response to respective phase calibration codes. When the memory is uncalibrated, the delay of the adjustable delay module in each clock distribution network may be set to a default value. The default value is a median value of the adjustable range of the adjustable delay module.

In summary, according to the clock transmission circuit provided according to the embodiments of the present disclosure, in the calibration mode, the first clock distribution network and the second clock distribution network transmit in-phase clock signals, and the delay of the second clock distribution network is adjusted according to the phase difference between the transmitted signals, thereby matching the delay of the first clock distribution network with the delay of the second clock distribution network. In this way, when the memory operates normally, the skew in the phase difference between the first target clock signal and the second target clock signal relative to the target value can be reduced, which is beneficial for data transmission. In addition, the setting of the calibration mode can also shorten the test time.

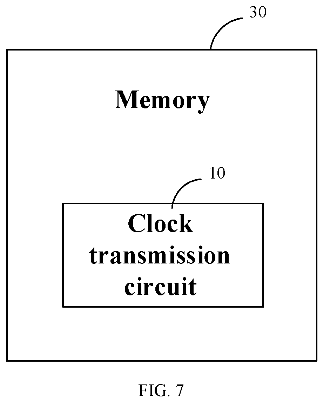

In yet another embodiment of the present disclosure, referring to FIG. 7, a schematic diagram of a composition structure of a memory 30 provided according to an embodiment of the present disclosure is shown. As shown in FIG. 7, the memory 30 at least includes the aforementioned clock transmission circuit 10.

In some embodiments, the memory at least conforms to one of the following specifications: DDR3 specification, DDR4 specification, DDR5 specification, DDR6 specification, LPDDR3 specification, LPDDR4 specification, LPDDR5 specification, and LPDDR6 specification.

According to the clock transmission circuit 10 included in the memory, when the memory is in the calibration mode, the first clock distribution network and the second clock distribution network transmit in-phase clock signals, and the delay of the second clock distribution network is adjusted according to the phase difference between the transmitted signals, thereby matching the delay of the first clock distribution network with the delay of the second clock distribution network. In this way, when the memory operates normally, the skew in the phase difference between the first target clock signal and the second target clock signal relative to the target value can be reduced, which is beneficial for data transmission. In addition, the setting of the calibration mode can also shorten the test time. Thus, the data strobe signal DQS can be accurately generated, and sampling processing of the data signal DQ can be performed more accurately, thereby enhancing the signal quality of the DQS and the DQ output by the memory.

In yet another embodiment of the present disclosure, referring to FIG. 6, a schematic flowchart of a method for phase calibration provided according to an embodiment of the present disclosure is shown. As shown in FIG. 6, the method is applied to a memory and may include the following steps.

In the step of S101, a first input clock signal is input to a first clock distribution network, the first input clock signal is transmitted to an output port area of the memory, and a first target clock signal is output; a second input clock signal is input to a second clock distribution network, the second input clock signal is transmitted to the output port area of the memory, and a second target clock signal is output.

In the step of S102, the second input clock signal is controlled to be in phase with the first input clock signal when the memory is in a calibration mode.

In the step of S103, the first target clock signal and the second target clock signal are received, and a first phase calibration code is output according to the phase difference between the first target clock signal and the second target clock signal.

In the step of S104, the delay of the second clock distribution network is adjusted according to the first phase calibration code, where the phase difference between the first target clock signal and the second target clock signal is less than a preset threshold when calibration is completed.

The method for phase calibration allows the first clock distribution network and the second clock distribution network to transmit in-phase clock signals and allows the delay of the second clock distribution network to be adjusted according to the phase difference between the transmitted signals, thereby matching the delay of the first clock distribution network with the delay of the second clock distribution network. In this way, when the memory operates normally, the skew in the phase difference between the first target clock signal and the second target clock signal relative to the target value can be reduced, which is beneficial for data transmission. In addition, the operation of detecting and aligning the first target clock signal and the second target clock signal in the method for phase calibration is simpler and more accurate than the adjustment based on the target value in the normal operating mode, and the test time can also be shortened.

The foregoing description shows merely preferred embodiments of the present disclosure and is not intended to limit the protection scope of the present disclosure. It should be noted that in the present disclosure, the terms "include", "comprise", or any other variants thereof are intended to cover non-exclusive inclusion, such that a process, a method, an item, or an apparatus including a series of elements includes not only those elements but also other elements not explicitly listed, or elements inherent to such process, method, item, or apparatus. Without further limitation, an element defined by the phrase "including a..." does not exclude the presence of additional identical elements in the process, method, item, or apparatus that includes the element. The serial numbers of the embodiments of the present disclosure described above are for the purpose of describing only and do not represent the superiority or inferiority of the embodiments. The methods disclosed in the method embodiments provided in the present disclosure may be combined in any manner, as long as there is no conflict, to obtain new method embodiments. The features disclosed in the product embodiments provided in the present disclosure may be combined in any manner, as long as there is no conflict, to obtain new product embodiments. The features disclosed in the method or device embodiments provided in the present disclosure may be combined in any manner, as long as there is no conflict, to obtain new method or device embodiments. The foregoing description is merely the specific embodiments of the present disclosure, but the protection scope of the present disclosure is not limited thereto; and changes or substitutions that any one skilled in the art can easily think of within the technical scope disclosed by the present disclosure shall all fall within the protection scope of the present disclosure. Therefore, the protection scope of the present disclosure shall be defined by the protection scope of the claims.

## Claims

1. A clock transmission circuit, applied to a memory, the clock transmission circuit comprising:
a first clock distribution network (11) configured to receive a first input clock signal, transmit the first input clock signal to an output port area of the memory, and output a first target clock signal;
a second clock distribution network (12) configured to receive a second input clock signal, transmit the second input clock signal to the output port area of the memory, and output a second target clock signal, wherein a phase difference between the second input clock signal and the first input clock signal is a preset value when the memory is in a normal operating mode, and the second input clock signal is in phase with the first input clock signal when the memory is in a calibration mode; and
a phase calibration module (13) configured to receive the first target clock signal and the second target clock signal and output, according to a phase difference between the first target clock signal and the second target clock signal, a first phase calibration code when the memory is in the calibration mode, wherein the first phase calibration code is used to adjust a delay of the second clock distribution network, and the phase difference between the first target clock signal and the second target clock signal is less than a preset threshold when calibration is completed.

2. The clock transmission circuit according to claim 1, further comprising:
a delay locked loop (14), wherein the delay locked loop at least comprises a first adjustable delay line (141), wherein the first adjustable delay line receives a first clock signal and a control code, performs delay processing on the first clock signal based on the control code, and outputs a first delayed clock signal; and
a multi-phase clock generation circuit (15) electrically connected to the first adjustable delay line and configured to: receive the first delayed clock signal and generate, based on the first delayed clock signal, at least a first phase clock signal and a second phase clock signal when an operating frequency of the memory is greater than or equal to a preset frequency, wherein the first phase clock signal is in phase with the first delayed clock signal, and a phase difference between the second phase clock signal and the first phase clock signal is the preset value; and be disabled when the operating frequency of the memory is less than the preset frequency.

3. The clock transmission circuit according to claim 2, further comprising:
a first mode control circuit (16) electrically connected to the multi-phase clock generation circuit, the first clock distribution network, and the second clock distribution network and configured to: receive the first phase clock signal and the second phase clock signal; transmit the first phase clock signal to the first clock distribution network as the first input clock signal and transmit the second phase clock signal to the second clock distribution network as the second input clock signal when the operating frequency of the memory is greater than or equal to the preset frequency and the memory is in the normal operating mode; and transmit the first phase clock signal to the first clock distribution network and the second clock distribution network as both the first input clock signal and the second input clock signal when the operating frequency of the memory is greater than or equal to the preset frequency and the memory is in the calibration mode.

4. The clock transmission circuit according to claim 3, wherein the delay locked loop further comprises a second adjustable delay line (142), wherein the second adjustable delay line is configured to: receive a second clock signal when the operating frequency of the memory is less than the preset frequency and the memory is in the normal operating mode; receive the first clock signal when the operating frequency of the memory is less than the preset frequency and the memory is in the calibration mode; perform delay processing on the received signal based on the control code and output a second delayed clock signal; and be disabled when the operating frequency of the memory is greater than or equal to the preset frequency.

5. The clock transmission circuit according to claim 4, wherein the first mode control circuit is further electrically connected to the second adjustable delay line, receives the second delayed clock signal, and transmits the first delayed clock signal to the first clock distribution network as the first input clock signal and transmits the second delayed clock signal to the second clock distribution network as the second input clock signal when the operating frequency of the memory is less than the preset frequency.

6. The clock transmission circuit according to claim 5, further comprising:
a second mode control circuit (17) electrically connected to the first adjustable delay line and the second adjustable delay line and configured to: transmit the first clock signal to the first adjustable delay line and transmit the second clock signal to the second adjustable delay line when the operating frequency of the memory is less than the preset frequency and the memory is in the normal operating mode; transmit the first clock signal to both the first adjustable delay line and the second adjustable delay line when the operating frequency of the memory is less than the preset frequency and the memory is in the calibration mode; and transmit the first clock signal to the first adjustable delay line when the operating frequency of the memory is greater than or equal to the preset frequency.

7. The clock transmission circuit according to claim 4, wherein the first adjustable delay line and the second adjustable delay line share a same circuit structure.

8. The clock transmission circuit according to claim 2, further comprising a clock distribution network replica (18) receiving the first input clock signal, emulating a delay of the first clock distribution network, and outputting a target clock signal replica.

9. The clock transmission circuit according to claim 8, wherein the delay locked loop further comprises:
a delay emulation circuit (143) receiving the target clock signal replica and configured to emulate delays of a clock input path and a clock output path in the memory and output a feedback clock signal, wherein the clock input path comprises a clock receiver and a frequency divider, and the clock output path comprises an output driving circuit;
a first phase detector (144) electrically connected to the delay emulation circuit and configured to receive the feedback clock signal and a reference clock signal and output, based on a phase sequence of the feedback clock signal and the reference clock signal, a first indication signal; and
a control code generation circuit (145) electrically connected to the first phase detector and configured to adjust and output the control code based on the first indication signal.

10. The clock transmission circuit according to claim 2, wherein the delay locked loop has completed phase locking before the memory enters the calibration mode.

11. The clock transmission circuit according to claim 1, wherein the phase calibration module comprises:
a second phase detector (131) receiving the first target clock signal and the second target clock signal and outputting, based on a phase sequence of the first target clock signal and the second target clock signal, a second indication signal; and
a first calibration code generation circuit (132) electrically connected to the second phase detector and configured to adjust and output the first phase calibration code based on the second indication signal.

12. The clock transmission circuit according to claim 11, wherein the second clock distribution network comprises an adjustable delay module, wherein the adjustable delay module receives the first phase calibration code and adjusts its own delay in response to the first phase calibration code.

13. The clock transmission circuit according to claim 12, wherein the adjustable delay module comprises a plurality of delay units, wherein each of the plurality of delay units is enabled or disabled in response to one bit in the first phase calibration code.

14. The clock transmission circuit according to claim 13, wherein the first calibration code generation circuit comprises:
a shift register configured to receive the second indication signal, perform a left shift or a right shift according to the second indication signal, and output the first phase calibration code.

15. The clock transmission circuit according to claim 1, further comprising:
a register configured to store the first phase calibration code after the calibration mode is completed and transmit the first phase calibration code to the second clock distribution network when the memory is in the normal operating mode.

16. The clock transmission circuit according to claim 1, wherein the phase calibration module stops operating after the calibration mode is completed.

17. The clock transmission circuit according to claim 6, further comprising:
a third clock distribution network configured to receive a third input clock signal, transmit the third input clock signal to the output port area of the memory, and output a third target clock signal, wherein a phase difference between the third input clock signal and the second input clock signal is 90 degrees when the memory is in the normal operating mode, and the third input clock signal is in phase with the first input clock signal when the memory is in the calibration mode; and
a fourth clock distribution network configured to receive a fourth input clock signal, transmit the fourth input clock signal to the output port area of the memory, and output a fourth target clock signal, wherein a phase difference between the fourth input clock signal and the third input clock signal is 90 degrees when the memory is in the normal operating mode, and the fourth input clock signal is in phase with the first input clock signal when the memory is in the calibration mode;
wherein the phase calibration module is further configured to: receive the third target clock signal and the fourth target clock signal and output, according to a phase difference between the third target clock signal and the first target clock signal, a second phase calibration code when the memory is in the calibration mode, wherein the second phase calibration code is used to adjust a delay of the third clock distribution network; and output, according to a phase difference between the fourth target clock signal and the first target clock signal, a third phase calibration code, wherein the third phase calibration code is used to adjust a delay of the fourth clock distribution network; when the calibration is completed, the phase difference between the first target clock signal and the third target clock signal is less than the preset threshold, and the phase difference between the first target clock signal and the fourth target clock signal is less than the preset threshold.

18. The clock transmission circuit according to claim 17, wherein the delay locked loop further comprises:
a third adjustable delay line configured to: receive a third clock signal when the operating frequency of the memory is less than the preset frequency and the memory is in the normal operating mode; receive the first clock signal when the operating frequency of the memory is less than the preset frequency and the memory is in the calibration mode; perform delay processing on the received signal based on the control code and output a third delayed clock signal; and be disabled when the operating frequency of the memory is greater than or equal to the preset frequency; and
a fourth adjustable delay line configured to receive a fourth clock signal when the operating frequency of the memory is less than the preset frequency and the memory is in the normal operating mode; receive the first clock signal when the operating frequency of the memory is less than the preset frequency and the memory is in the calibration mode; perform delay processing on the received signal based on the control code and output a fourth delayed clock signal; and be disabled when the operating frequency of the memory is greater than or equal to the preset frequency;
wherein phases of the first clock signal, the second clock signal, the third clock signal, and the fourth clock signal differ successively by 90 degrees.

19. The clock transmission circuit according to claim 18, wherein the multi-phase clock generation circuit is further configured to generate a third phase clock signal and a fourth phase clock signal based on the first delayed clock signal, wherein phases of the first phase clock signal, the second phase clock signal, the third phase clock signal, and the fourth phase clock signal differ successively by 90 degrees;
the first mode control circuit is further electrically connected to the third adjustable delay line and the fourth adjustable delay line and configured to: receive the third phase clock signal, the fourth phase clock signal, the third delayed clock signal, and the fourth delayed clock signal; transmit the third phase clock signal to the third clock distribution network as the third input clock signal and transmit the fourth phase clock signal to the fourth clock distribution network as the fourth input clock signal when the operating frequency of the memory is greater than or equal to the preset frequency and the memory is in the normal operating mode; transmit the first phase clock signal to the third clock distribution network and the fourth clock distribution network as both the third input clock signal and the fourth input clock signal when the operating frequency of the memory is greater than or equal to the preset frequency and the memory is in the calibration mode; and transmit the third delayed clock signal to the third clock distribution network as the third input clock signal and transmit the fourth delayed clock signal to the fourth clock distribution network as the fourth input clock signal when the operating frequency of the memory is less than the preset frequency; and
the second mode control circuit is further electrically connected to the third adjustable delay line and the fourth adjustable delay line and configured to: transmit the third clock signal to the third adjustable delay line and transmit the fourth clock signal to the fourth adjustable delay line when the operating frequency of the memory is less than the preset frequency and the memory is in the normal operating mode; and transmit the first clock signal to both the third adjustable delay line and the fourth adjustable delay line when the operating frequency of the memory is less than the preset frequency and the memory is in the calibration mode.

20. The clock transmission circuit according to claim 18, wherein clock frequencies of the first clock signal, the second clock signal, the third clock signal, and the fourth clock signal are half of a clock frequency of an initial clock signal received by the memory, wherein the clock frequency of the initial clock signal is equal to the operating frequency of the memory.

21. The clock transmission circuit according to claim 17, wherein the phase calibration module comprises:
a third phase detector receiving the first target clock signal and the third target clock signal and outputting, based on a phase sequence of the first target clock signal and the third target clock signal, a third indication signal;
a second calibration code generation circuit electrically connected to the third phase detector and configured to adjust and output the second phase calibration code based on the third indication signal;
a fourth phase detector receiving the first target clock signal and the fourth target clock signal and outputting, based on a phase sequence of the first target clock signal and the fourth target clock signal, a fourth indication signal; and
a third calibration code generation circuit electrically connected to the fourth phase detector and configured to adjust and output the third phase calibration code based on the fourth indication signal.

22. A method for phase calibration, applied to a memory, the method comprising:
inputting a first input clock signal to a first clock distribution network, transmitting the first input clock signal to an output port area of the memory, and outputting a first target clock signal;
inputting a second input clock signal to a second clock distribution network, transmitting the second input clock signal to the output port area of the memory, and outputting a second target clock signal;
controlling the second input clock signal to be in phase with the first input clock signal when the memory is in a calibration mode;
receiving the first target clock signal and the second target clock signal, and outputting, according to a phase difference between the first target clock signal and the second target clock signal, a first phase calibration code; and
adjusting a delay of the second clock distribution network according to the first phase calibration code, wherein the phase difference between the first target clock signal and the second target clock signal is less than a preset threshold when calibration is completed.

23. A memory, comprising the clock transmission circuit according to any one of claims 1 to 21.
